# EUROPEAN PATENT SPECIFICATION

(11) **EP 4 536 457 B1**
(45) Date of publication and mention of the grant of the patent: **27.08.2025**
(21) Application number: 23730782.2
(22) Date of filing: 02.06.2023
(51) Int. Cl.: B23D 59/00, B28D 5/00, B28D 5/04

(54) **CRYSTAL WAFERING SYSTEM AND METHOD**
KRISTALL-WAFER-SYSTEM UND VERFAHREN
SYSTÈME ET PROCÉDÉ DE DÉCOUPE DE WAFERS

(30) Priority: 10.06.2022 EP 22178401
(43) Date of publication of application: 16.04.2025
(73) Proprietor: Scientific Visual SA, 1020 Renens VD (CH)
(72) Inventor: FALISE, Frédéric, 1294 Genthod (CH); ORLOV, Ivan, 1006 LAUSANNE (CH)
(74) Representative: reuteler & cie SA
(86) International application number: PCT/EP2023/064884
(87) International publication number: WO 2023/237451

(56) References cited:
- WO-A1-2012/150517
- JP-A- 2014 175 370
- RU-C1- 2 750 068
- US-A1- 2015 092 920
- US-A1- 2022 126 395

## Description

### Field of the invention

The present invention relates to a method of wafering a crystal, in particular large crystals such as sapphire, silicon or silicon carbide crystals for optical or electronic application: The present invention also relates to a system for producing wafers from an industrially grown crystal.

### Background of the invention

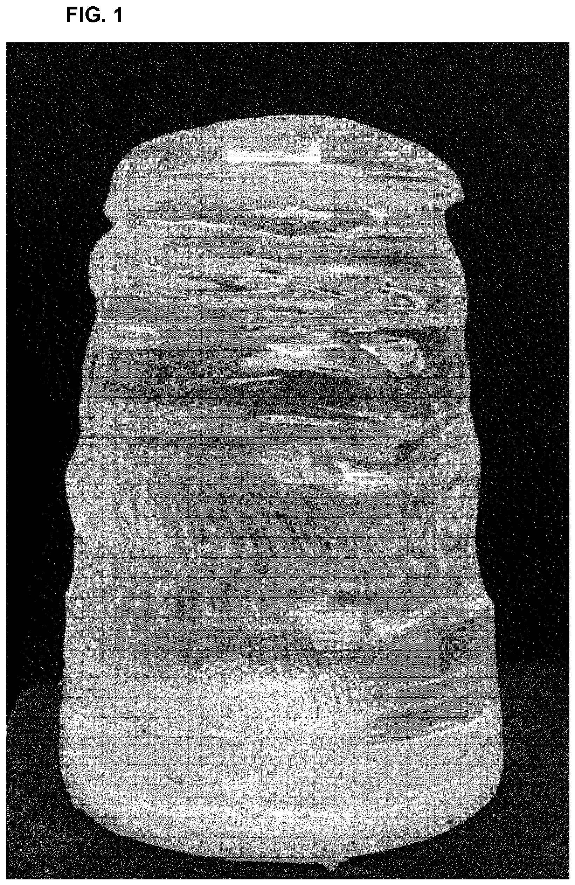

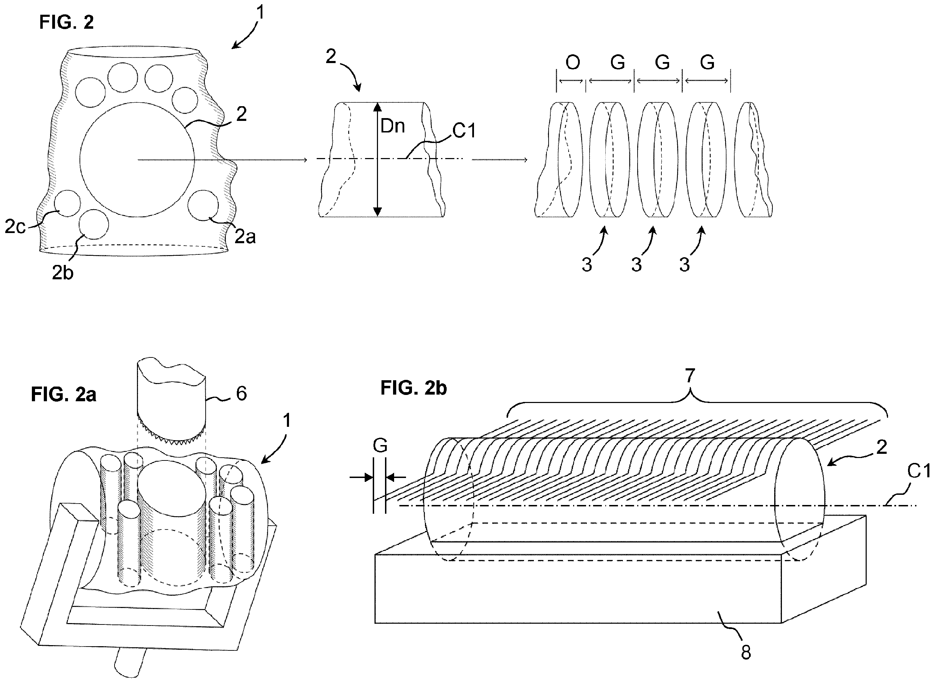

Industrially grown crystals such as sapphire crystals may typically weigh a few kilograms to hundreds of kilograms and have approximately conical / cylindrical irregular outer shapes. From this irregular 3D shape, as illustrated in the photograph of figure 1 showing an industrially grown sapphire crystal, a typical process is to extract cylindrical cores and then to slice these cylindrical cores into discs or circular wafers as illustrated in figure 2. The orientation of the axis of the cylindrical core is in a defined direction with respect to the crystalline structure of the crystal, for instance it may correspond to one of the optical axes of the crystal. Usually, industrial applications will require discs or wafers of certain diameters and thicknesses, and depending on the size and shape of the raw crystal the position and number of the cylindrical cores will vary from one raw crystal to the next.

It is understood that, in a general case, the extracted core may have round, rectangular or any other section. It is also understood that "disc" or "wafer" are generic terms for parallel parts sliced of the said core, irrelevant to shape or thickness it has.

In conventional processes, the crystalline structure axes are determined by measurements performed with X-ray or optical measurement tools, and the optimum distribution of cores to be extracted from a specific crystal may be performed with the aid of a human operator that decides on the best layout.

These processes are however time intensive and costly. Moreover, there is a certain amount of waste due to internal defects present in the crystal and that end up in the discs or wafers that are sliced out of the selected cores. As the growth of such crystals is time consuming and costly, there would be an advantage in reducing the amount of waste material and the discs or wafers with defects

Document WO 2012/150517 A1 discloses a method of producing wafers or discs from an industrially grown crystal comprising the steps of scanning a crystal model of the crystal; measuring one or more crystal axes provided by a crystalline structure of the crystal; coring out one or more cores from the crystal in a selected crystal direction which is parallel to one of said crystal axes or at a defined angle with respect to said crystal axis; and slicing the core orthogonally to the selected crystal direction with a wafer slicing machine comprising a slicing tool comprising a plurality of cutting wires or blades spaced at a regular slicing pitch configured to cut wafers of identical thicknesses from the core.

### Summary of the invention

In view of the foregoing, it is an object of this invention to provide a system and method for wafering industrially grown crystals that reduces waste and increases the yield of the wafering process.

It is advantageous to provide a wafering processing for industrially grown crystals that allows to produce crystal discs or wafers of very high quality with a low rate of defects.

It is advantageous to provide a process for wafering industrially grown crystals that is rapid and economical, in particular that increases automation and reduces human operator intervention.

According to the invention, a method of producing wafers or discs from an industrially grown crystal, is defined by the features of claim 1

According to the invention, there is provided a method of producing wafers from an industrially grown crystal comprising the steps of:
- scanning a crystal in volume and forming a 3D volumetric digital model of the crystal,
   recording 3D spatial coordinates of defects detected during said scanning,
- measuring one or more crystal axes (C1, C2, C3) provided by a crystalline structure of the crystal, and recording this crystal axis in said 3D model of the crystal,
- coring out one or more cores from the crystal in a selected crystal axis direction which is parallel to one of said crystal axes or at a defined angle with respect to said crystal axis,
- slicing the core orthogonally to the selected crystal direction with a wafer slicing machine comprising a slicing tool comprising a plurality of cutting wires or blades spaced at a regular slicing pitch (G) configured to cut wafers of identical thicknesses (S) from the core,
   wherein the method includes
- computing an offset position (O) of the slicing tool along the selected crystal direction configured to have a minimum number of discs or wafers with defects, and
- adjusting the position of the slicing tool relative to the core along the selected crystal direction according to the computed offset.

In an embodiment, the offset position has an amplitude varying in a range of 0 to said slicing pitch (G) thickness of the wafers.

In an advantageous embodiment, the scanning of the crystal comprises an optical scanning of the crystal. In an advantageous embodiment, the core is placed in a holder, the holder and core positioned in the slicing machine.

In an advantageous embodiment, the crystal axis of the core is measured once more after the core has been cut out of the crystal and the core axis position is adjusted by means of the holder such that the slicing tool cuts wafers orthogonally to the adjusted crystal axis.

In an advantageous embodiment, a largest diameter core *(Dmax)* cut out of the crystal is positioned such that a minimum number of defects are found, by computation using the 3D volumetric digital model, in the wafers to be cut out of the crystal.

In an advantageous embodiment, the absolute value of the offset is calculated from a reference position on the surface of the crystal prior to the coring operation.

In an advantageous embodiment, the scanning step of defects and geometry of the crystal is performed after a cropping operation of top and/or bottom ends of the raw crystal.

In an advantageous embodiment, the crystal comprises a plurality crystal axes, the method comprising generating flat planes intersecting the core or the wafers, the flat planes parallel to an axis of the core and orthogonal to the crystal axes, computing a number of defects between said flat planes and an outer contour of the core or wafers, selecting one of said flat planes for cutting for which a maximum number of defects are positioned within the removed area between the flat plane and the outer contour.

In an advantageous embodiment, a non-circular pattern such as a pattern for semi-conductor chips to be cut out of a wafer are oriented according to one of a plurality of crystal axes (C2, C3) computed such that a minimum number of defects are found within the area of the chips or within a minimum number the chips, and a maximum number of defects are found within a removed area between an outer contour of the pattern of chips and an outer circular periphery of the wafer.

In an advantageous embodiment, said pattern of chips is included in a 3D volumetric digital model of the crystal for computation of the offset to take into account the defects positioned in a waste area between the outer diameter of the wafer and the chips to be cut out of the wafer.

According to the invention, there is also provided a system for producing wafers from an industrially grown crystal comprising:
a scanner for scanning a crystal in volume and a program module configured for forming a 3D volumetric digital model of the crystal from an output of the scanner,
the program module further configured for recording 3D spatial coordinates of defects detected by the scanner,
wherein the program module is configured to compute an offset position (O) of a slicing tool along a selected crystal axis configured to have a minimum number of wafers with defects.

In an advantageous embodiment, the scanner for scanning the crystal comprises an optical scanner.

In an advantageous embodiment, the system further comprises:
a measuring device for measuring one or more crystal axes (C 1, C2, C3) provided by a crystalline structure of the crystal, and recording said one or more crystal axes in said 3D model of the crystal.

In an advantageous embodiment, the system further comprises:
a coring device for cutting out one or more cylindrical cores (2) from the crystal (1) in a selected crystal axis direction, and
a wafer slicing machine comprising a slicing tool comprising a plurality of cutting wires or blades spaced at a regular slicing pitch (G) configured to cut wafers of identical thicknesses (S) from the core.

The system may be configured to carry out any of the above described embodiments of a method to produce wafers.

Further objects and advantageous aspects of the invention will be apparent from the claims, and from the following detailed description and accompanying figures.

### Brief description of the drawings

**Figure 1** is a photograph of an industrially grown sapphire crystal;
**Figure 2** is a schematic representation of a *per se* known wafering process of an industrially grown crystal depicting a raw crystal and a selected position of crystal cores and the slicing of one of the cores into circular discs;
**Figure 2a** is a simplified schematic representation of a core cutting tool and a crystal;
**Figure 2b** is a simplified schematic perspective illustration of a cylindrical crystal core placed on a crystal core support being sliced into discs by a wire cutter;
**Figure 3a** is a schematic representation of a cylindrical core that has been cut out of a raw crystal prior to slicing into discs, with some defects positioned within the core;
**Figure 3b** is a simplified schematic representation of a cutting grid and wafers in a core of a crystal;
**Figure 3c** is a representation similar to figure 3a illustrating an optimal cutting arrangement with respect to the defects illustrated in figure 3a and
**Figure 3d** is an illustration of a cutting arrangement of the example of figure 3a that is non-optimized;
**Figure 4** is a schematic plan view of a core in which a flat surface parallel to the cylinder axis is required;
**Figure 5** is a schematic plan view of a wafered semi-conductor disc, for instance of a silicon carbide crystal, showing positions of semi-conductor chips to be cut out of the disc;

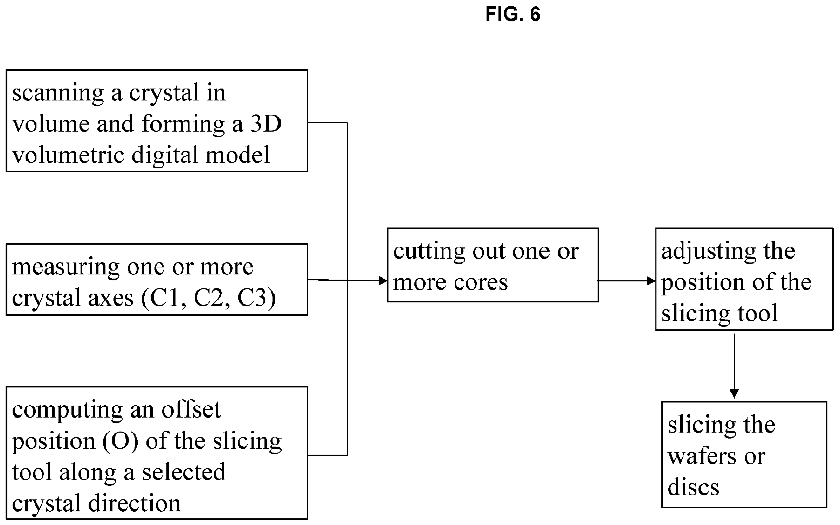

**Figure 6** is a block diagram illustrating a method according to an embodiment of the invention.

### Detailed description of the invention

Referring to the figures, a raw industrially grown crystal 1 has a roughly conical irregular 3D shape 9 and possesses a crystalline structure that defines one or more crystal axes corresponding to specific orientation of the crystal lattice. For instance, in the case of sapphire crystals there is an optical axis (also commonly named the *c-axis*) **C1** that eliminates the inherent birefringent properties of the sapphire crystal. The selected crystal axis **C1** may lie also within the crystal plane that is the most resistant to forces applied perpendicular to that plane. This plane can be as high as 20% harder to process, compared to other crystallographic orientations. In many applications, it is desired to cut the wafers at a specified angle to one or several axes, for example orthogonally to the optical axis ***C1**.*

For semi-conductor circuits, the orientation of the crystal lattice is also important and the wafers should be cut with respect to a specific direction in the crystal. The crystal lattice directions may be determined by various *per se* well known measurement means, for instance using optical or x-ray measurement systems.

Once the axes are determined, the orientation of cylindrical cores, from which the disc or wafers shall be cut, may be defined within the volume of the raw crystal. For many applications, the desired diameters *Dn* of the wafers are pre-defined, whereas in a raw crystal, wafers of different diameters or surface areas may be extracted for potentially different applications or for the same application. With regards to sapphire crystals for instance, different diameters wafers may be used to produce lenses of different sizes for optical instruments. Typically, the larger diameter wafers are more valuable and rarer, and obviously less of them may be extracted (sometimes only one) per raw crystal.

After determination of the selected cores, appropriate core cutting tools 6 may be used to cut out the cylindrical cores 2, 2a, 2b, 2c.

For the subsequent wafer slicing process, the core is typically placed in a polymer holder or support 8 that is bonded to the crystal core and sacrificed during the wafer slicing process.

The support 8 may be manufactured by additive processes such as 3D printing, or by moulding processes, or subtractive processes such as machining out of a block of support material and adjusted for the shape and size of the core. In this regard, although the crystal axis, such as the optical axis C1, is determined to extract a core, its measurement may be slightly inaccurate and a further correction for the crystal axis may be performed by the position of the core 2 within the support 8. This will allow for instance the wafers to be cut with greater accuracy orthogonally to the measured crystal axis C1, the support 8 being positioned within the wafer slicing machine.

A disc or wafer slicing machine is typically formed of a plurality of wires (typically diamond coated wires or blades) that are arranged at a regular spacing and that cut through the core orthogonally to a specific direction (for example, the optical axis).

It may be noted that the coring direction may be defined by a crystal axis, but is not always equal to it. For example, in some applications the sapphire is cut at and angle of 20.5 degrees off to the optical axis. The term 'crystal direction' as used herein corresponds to the 'coring direction' which as mentioned may be parallel to a crystal lattice axis or at a defined angle with respect to the crystal lattice axis.

A cooling and lubrification fluid may be used during coring and slicing, such process typically taking hours or days. The coring and slicing processes of wafers are *per se* well known processes and do not need to be further described herein. The two discs at the core ends may be rejected as waste and the slices are then typically re-inspected to determine those that are free of defects, or having defects below an accepted threshold, those having defects above the threshold being rejected. In many industrial wafering processes, it is typical for about 5% to 30% of sliced discs to be rejected due to internal crystal defects, this however depending very much on the quality of the crystal itself and diameter of the discs or wafers.

According to an aspect of the invention, prior to the coring process, but optionally subsequent to a boule cropping and top end and bottom end grinding or slicing process, a full 3D scan of the crystal is performed and the three-dimensional X, Y, Z coordinates of each defect within the volume of the crystal are mapped. These X, Y, Z coordinates may be mapped relative to a geometrical reference (point, line, surface) fixed relative to the crystal or relative to an edge of the core. The raw crystal, or a holder fixed to the raw crystal may be marked with a reference point or shape. A digitalized 3D model of the crystal may thus be constructed with the defects positioned therein.

The crystal axes are measured by *per se* known measurement instruments such as using x-ray and these crystal axes directions are also recorded in the digitalized 3D model of the crystal.

The cores may then be selected for cutting out of the crystal in the selected crystal axis direction, the positions of the cores being optimized in order to ensure that the most valuable cores, which are the largest cores, have the least defects within their volume. This optimization may be performed with the aid of a computer program, that seeks to minimize the number of defects in a core of a given diameter by varying the position of the core within the raw crystal and counting the defects for each position.

The computer aided optimization process may thus be configured to place the largest diameter core in the most optimal position, namely the position with the least amount of defects within the volume of the core, and subsequently position the remaining smaller diameter cores in the remaining volume around the largest core. If there is a largest core and a second largest core and then cores of smaller size than the second largest, the optimization process may position the second largest core in an optimal position for the least amount of defects within this core prior to positioning the remaining cores. Depending on the application, the cores may have pre-defined diameters, or their diameter may be different from a single large core with the largest possible diameter within the raw crystal and other cores of smaller diameters in order to optimize the volume of useful material and reduce the volume of waste material. The latter would depend on the requirements for the wafers depending on the intended applications. Alternatively, the optimisation could be done to maximise value of all extracted cores jointly.

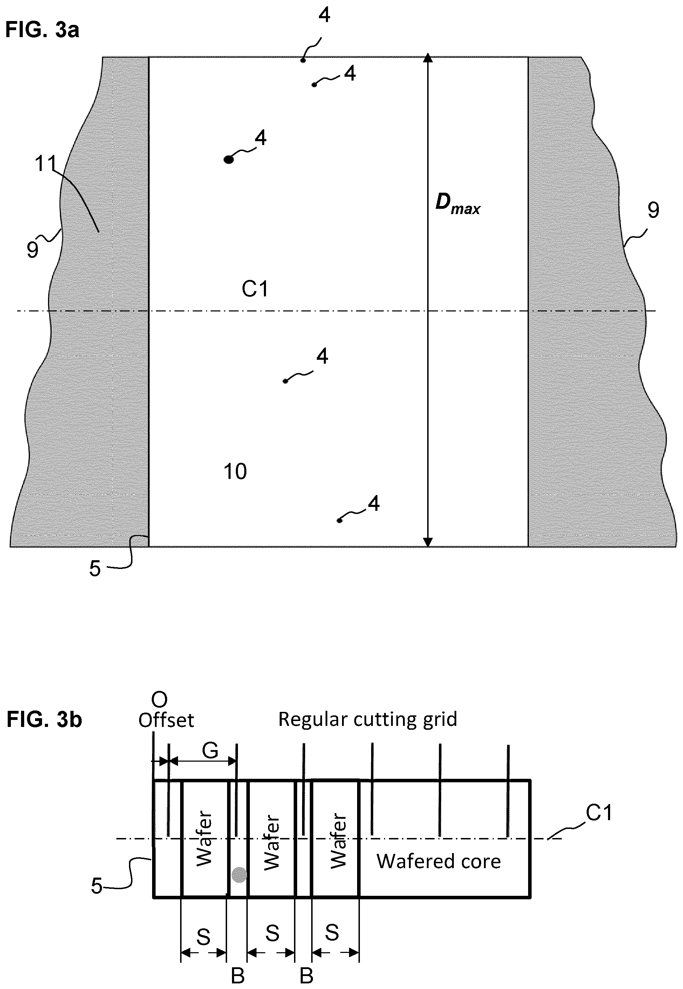

Figure 3a illustrates a core, for instance of the largest diameter *Dmax* extracted from a raw crystal, having a useful volume 10 from which wafers may be cut orthogonal to the crystal axis ***C1**.* As mentioned above, the wafers are typically required for a specific application and are required with a certain thickness ***S*** that is cut with a wire cutter having a regular cutting grid.

Depending on the position of the cutting grid wires along the crystal axis there may be, according to an aspect of the invention, a certain number of discs with defects 4 ranging between a minimum number of discs with defects and a maximum number of discs with defects. The spacing between the cutting wires corresponds to the range of possible axial positions for the wire that can be adjusted to optimize the number of non-defective discs, i.e. discs not including defects or including only defects below an acceptable threshold that is defined by the requirements of the application.

According to an aspect of the invention, the position of the cutting wires is adjusted with an offset of an amount ***O*** that is in a range between 0 and the grid spacing G between cutters 7. The offset ***O*** may be added to an absolute value from a reference plane or point, for instance an end face 5 of the core or any other fixed reference point or shape on the raw crystal 1, crystal core 2, or the holder 8. This process may be automated in a simple manner using the digital 3D model of the crystal in which the X, Y, Z positions of the defects and the crystal axis direction are recorded, whereby the calculation of the optimal offset may be done at any time prior to the wafer slicing, including prior to the coring of the crystal cores 2 from the raw crystal 1. The position of the offset ***O*** may be adjusted for any other reference positions, for instance provided on the core holder. The offset position and correction of the position of the crystal with respect to the machine may be made either by repositioning the core on the holder, or adjusting the geometry of the holder to present a reference surface thereon that adjusts a position of the holder 8 with respect to the cutting machine, or that sends instructions to the cutting machine to adjust the position of the holder such that the calculated offset correctly positions the cutting grid with respect to a reference position of the core or its holder.

In the calculation of the offset, the thickness of the material that is removed during the slicing process is taken into account whereby the optimization process may vary the offset from 0 to the grid pitch G in order to determine the number of wafer slices with defects below a pre-defined accepted threshold, whereby some defects may be within the thickness B of the removed material and thus no longer present in the wafers, or defects that may be in two adjacent wafers are shifted into a single wafer.

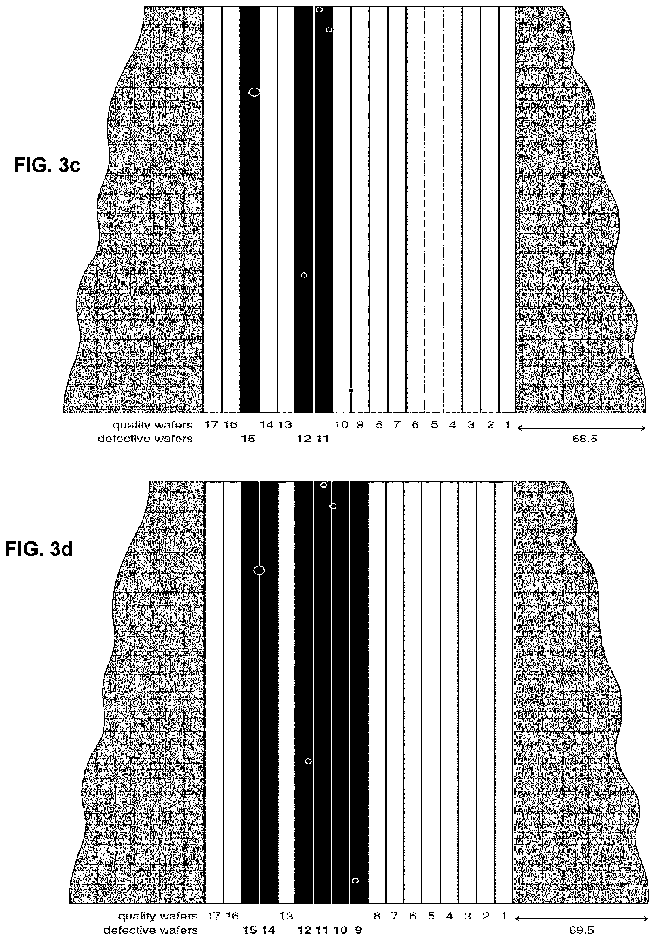

In figure 3c, taking example from the defects found in the example of figure 3a, the offset is calculated from a reference point on an outer point on the surface 9 of the crystal corresponding to an offset to 68.5 mm resulting in the defects being found in three of the eighteen wafer slices. These three wafers are represented by black areas on the Figure 3c. In a non-optimal offset of 69.5 mm in this specific example, there are six wafer slices that contain the defects (Figure 3d). There is therefore an important advantage is this single example to calculate an optimal offset and to offset the position of the wire grid along the selected crystal axis in order to reduce waste. Moreover, the scanning of the defects and subsequent 3D modelization of the spatial coordinates of the defects as well as the crystal axes and outer profile of the crystal serving to provide reference points, enables an automated accurate adjustment of the optimal cutting arrangement to reduce waste.

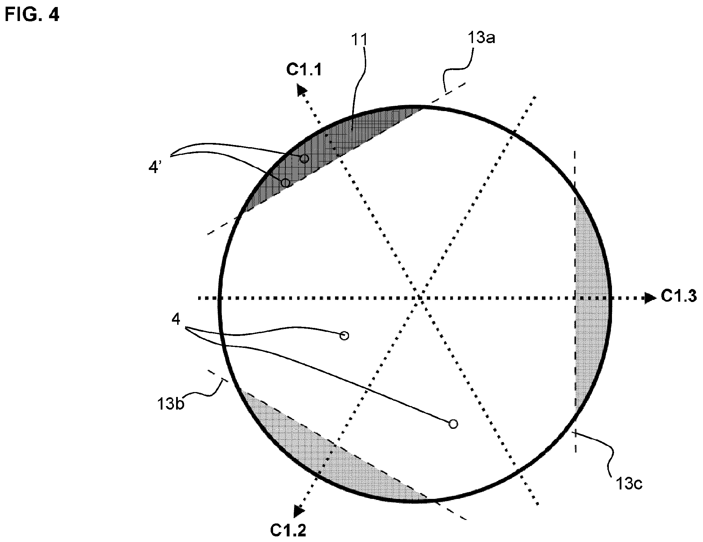

Referring to figure 4, in certain applications, a flat surface parallel to the cylinder axis and orthogonal to a crystal axis or a crystal direction, is required. In some crystals such axis or a direction is replicated by crystal symmetry, therefore, offering plurality of equivalent directions C1.1, C1.2, C1.3 for positioning the flat plane. In such applications, the spatial coordinates of the defects 4, 4' may also be used to optimize the selection of a flat cutting plane 13a, 13b, 13c forming a chord of the cylinder to produce the flat chord surface with the most defects 4' in the waste volume 11. The cutting of a flat chord surface out of the core or wafer disc may be used in various applications, including, for instance, marking crystal lattice orientation in semi-conductor crystals.

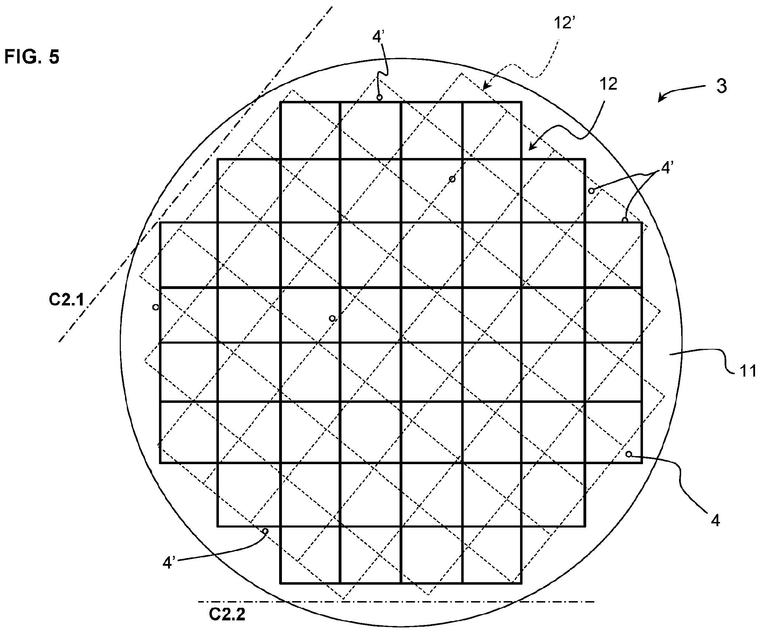

Referring to figure 5, the spatial coordinates of the defects 4, 4' may also be used to optimize the selection of the cutting offset and also the subsequent orientation of the chips according to one of equivalent crystal directions C2.1, C2.2 (e.g. parallel or orthogonal to the crystal axes) from which they can be geometrically oriented by rotating the surface area covered by the chips 12 such that the most inclusions possible are found in the waste area 11 between the outer circular periphery and the rectangular profiles of the chips. In the example illustrated in figure 4, it is preferable to orient the chips 12 according to the crystal direction C2.2, rather than the crystal axis C2.1, since in the first angular orientation aligned with crystal direction C2.2 there are less defects 4 in the area covered by the chips 12 than in the second angular orientation C2.1 where there are more defects 4' in the area covered by the chips 12'.

If a crystal is used for an application in which chips should be extracted as shown in figure 5, for instance semi-conductor chips from a silicon carbide crystal, the offset may also be adjusted to take into account the inclusions that are in the periphery and that will be found in the waste volume 11 between the circular periphery of the disc wafer and the actual chips.

### List of feature references:

Coring machine
   Core cutting tool 6
Slicing machine
   slicing wires 7
Crystal support 8
3D inspection machine
Raw crystal 1
   Outer profile / surface 9
   Useful volume 10
   Waste volume 11
   Defects 4
   Flat cut 13
Cylindrical Cores 2, 2a, 2b, 2c
   End face 5
   Reference surface
Discs / wafers 3
Chips 12
Crystal axis ***C1, C2, C3***
   e.g. Optical axis
Equivalent crystal directions ***C1.1, C1.2, C1.3 and C2.1, C2.2***
   e.g. Crystal axes
core diameter ***Dn***
Disc or wafer slice thickness ***S***
Cutting blade thickness ***B***
Offset ***O***

## Claims

1. A method of producing wafers or discs from an industrially grown crystal comprising the steps of:
- scanning a crystal (1) in volume and forming a 3D volumetric digital model of the crystal,
- recording 3D spatial coordinates of defects (4, 4') detected during said scanning,
- measuring one or more crystal axes (C1, C2, C3) provided by a crystalline structure of the crystal, and recording this crystal axis in said 3D model of the crystal,
- coring out one or more cores (2) from the crystal (1) in a selected crystal direction which is parallel to one of said crystal axes or at a defined angle with respect to said crystal axis,
- slicing the core orthogonally to the selected crystal direction with a wafer slicing machine comprising a slicing tool comprising a plurality of cutting wires or blades spaced at a regular slicing pitch (G) configured to cut wafers of identical thicknesses (S) from the core,
- wherein the method includes computing an offset position (O) of the slicing tool along the selected crystal direction configured to have a minimum number of wafers with defects, and
- adjusting the position of the slicing tool relative to the core along the selected crystal direction according to the computed offset.

2. The method according to the preceding claim wherein the offset position has an amplitude varying in a range of 0 to said slicing pitch (G) thickness of the wafers.

3. The method according to any preceding claim wherein the scanning of the crystal includes optically scanning the crystal.

4. The method according to any preceding claim wherein the core (2) is placed in a holder (8), the holder and core positioned in the slicing machine.

5. The method according to the preceding claim wherein the crystal axis of the core is measured once more after the core has been cut out of the crystal and the core axis position is adjusted by means of the holder such that the slicing tool cuts wafers orthogonally to the adjusted crystal axis.

6. The method according to any preceding claim wherein a largest diameter core ***(Dmax)*** cut out of the crystal is positioned such that a minimum number of defects are found, by computation using the 3D volumetric digital model, in the wafers to be cut out of the crystal.

7. The method according to any preceding claim wherein the absolute value of the offset is calculated from a reference position on the surface of the crystal prior to the coring operation.

8. The method according to any preceding claim wherein the scanning step of defects and geometry of the crystal is performed after a cropping operation of top and/or bottom ends of the raw crystal.

9. The method according to any preceding claim wherein the crystal comprises a plurality of equivalent crystal axes or a plurality of equivalent crystal directions (C1.1, C1.2, C1.3), the method comprising generating flat planes (13a, 13b, 13c) intersecting the core or the wafers, the flat planes parallel to an axis of the core and orthogonal to the crystal axes, computing a number of defects between said flat planes and an outer contour of the core or wafers, selecting one of said flat planes for cutting for which a maximum number of defects (4') are positioned within the waste area (11) between the flat plane and the outer contour.

10. The method according to any preceding claim wherein a non-circular pattern such as a pattern for semi-conductor chips (12) to be cut out of a wafer (3) are oriented according to one of a plurality of crystal directions (C2.1, C2.2) computed such that a minimum number of defects (4) are found within the area of the chips or within a minimum number the chips, and a maximum number of defects are found within a waste area (11) between an outer contour of the pattern of chips and an outer circular periphery of the wafer.

11. The method according to the preceding claim wherein said pattern of chips is included in a 3D volumetric digital model of the crystal for computation of the offset to take into account the defects positioned in a waste area (11) between the outer diameter of the wafer and the chips to be cut out of the wafer.

12. A system for producing wafers from an industrially grown crystal, configured to carrying-out the method of any of claims 1 to 11, comprising:
- a scanner for scanning a crystal (1) in volume and a program module configured for forming a 3D volumetric digital model of the crystal from an output of the scanner,
- the program module further configured for recording 3D spatial coordinates of defects (4, 4') detected by the scanner,
- wherein the program module is configured to compute an offset position (O) of a slicing tool along a selected crystal axis configured to have a minimum number of wafers with defects.

13. The system according to the preceding claim further comprising:
- a measuring device for measuring one or more crystal axes (C1, C2, C3) provided by a crystalline structure of the crystal, and recording said one or more crystal axes in said 3D model of the crystal.

14. The system according to either of the two directly preceding claims further comprising:
- a coring device for cutting out one or more cylindrical cores (2) from the crystal (1) in a selected crystal axis direction, and
- a wafer slicing machine comprising a slicing tool comprising a plurality of cutting wires or blades spaced at a regular slicing pitch (G) configured to cut wafers of identical thicknesses (S) from the core.

## Patentansprüche

1. Verfahren zur Herstellung von Wafern oder Scheiben aus einem industriell gezüchteten Kristall, das die folgenden Schritte umfasst:
- Abtasten des Volumens eines Kristalls (1) und Bilden eines digitalen volumetrischen 3D-Modells des Kristalls,
- Aufzeichnen von 3D-Raumkoordinaten von Defekten (4, 4'), die während des Abtastens festgestellt werden,
- Messen einer oder mehrerer Kristallachsen (C1, C2, C3), die von der kristallinen Struktur des Kristalls bereitgestellt werden, und Aufzeichnen dieser Kristallachse/n in dem 3D-Modell des Kristalls,
- Auskernen eines oder mehrerer Kerne (2) von dem Kristall (1) in einer ausgewählten Kristallrichtung, die parallel zu einer der Kristallachsen ist, oder in einem definierten Winkel in Bezug auf die Kristallachse,
- In-Scheiben-Schneiden des Kerns orthogonal zur ausgewählten Kristallrichtung mit einer Wafer-Schneidemaschine, die ein Schneidwerkzeug umfasst, das eine Vielzahl von Schneiddrähten oder -klingen umfasst, die in einem gleichmäßigen Schneidabstand (G) beabstandet sind und dazu ausgestaltet sind, Wafer mit identischen Dicken (S) aus dem Kern auszuschneiden,
- wobei das Verfahren das Berechnen einer Versatzposition (O) des Schneidwerkzeugs entlang der ausgewählten Kristallrichtung umfasst, die so ausgestaltet ist, dass eine minimale Anzahl von Wafern mit Defekten vorliegt, und
- Anpassen der Position des Schneidwerkzeugs in Bezug auf den Kern entlang der ausgewählten Kristallrichtung gemäß dem berechneten Versatz.

2. Verfahren nach dem vorhergehenden Anspruch, wobei die Versatzposition einen Ausschlag aufweist, der in einem Bereich von 0 bis zu der Dicke des Schneidabstands (G) der Wafer variiert.

3. Verfahren nach einem der vorhergehenden Ansprüche, wobei das Abtasten des Kristalls das optische Abtasten des Kristalls umfasst.

4. Verfahren nach einem der vorhergehenden Ansprüche, wobei der Kern (2) in einem Halter (8) platziert wird, wobei der Halter und der Kern in der Schneidmaschine positioniert werden.

5. Verfahren nach dem vorhergehenden Anspruch, wobei die Kristallachse des Kerns ein weiteres Mal gemessen wird, nachdem der Kern aus dem Kristall ausgeschnitten wurde, und die Kernachsenposition derart mittels des Halters angepasst wird, dass das Schneidwerkzeug Wafer orthogonal zur angepassten Kristallachse schneidet.

6. Verfahren nach einem der vorhergehenden Ansprüche, wobei ein Kern mit einem größten Durchmesser (***Dmax***), der aus dem Kristall ausgeschnitten wird, derart durch Berechnung unter Verwendung des digitalen volumetrischen 3D-Modells positioniert wird, dass in den aus dem Kristall auszuschneidenden Wafern eine minimale Anzahl von Defekten angetroffen werden.

7. Verfahren nach einem der vorhergehenden Ansprüche, wobei der Absolutwert des Versatzes von einer Bezugsposition auf der Oberfläche des Kristalls vor dem Auskernvorgang berechnet wird.

8. Verfahren nach einem der vorhergehenden Ansprüche, wobei der Schritt des Abtastens von Defekten und Geometrie des Kristalls nach einem Beschneidungsvorgang des oberen und/oder unteren Endes des Rohkristalls durchgeführt wird.

9. Verfahren nach einem der vorhergehenden Ansprüche, wobei der Kristall eine Vielzahl von äquivalenten Kristallachsen oder eine Vielzahl von äquivalenten Kristallrichtungen (C1.1, C1.2, C1.3) umfasst, wobei das Verfahren das Erzeugen flacher Ebenen (13a, 13b, 13c), welche den Kern oder die Wafer schneiden, wobei die flachen Ebenen parallel zu einer Achse des Kerns und orthogonal zu den Kristallachsen sind, das Berechnen einer Anzahl von Defekten zwischen den flachen Ebenen und einer äußeren Kontur des Kerns oder der Wafer, das Auswählen einer der flachen Ebenen zum Schneiden umfasst, für die eine maximale Anzahl von Defekten (4') innerhalb des Verschnittbereichs (11) zwischen der flachen Ebene und der äußeren Kontur positioniert sind.

10. Verfahren nach einem der vorhergehenden Ansprüche, wobei eine nicht kreisförmige Struktur, wie eine Struktur für Halbleiterchips (12), die aus einem Wafer (3) auszuschneiden sind, gemäß einer der Vielzahl von Kristallrichtungen (C2.1, C2.2) ausgerichtet wird, die derart berechnet werden, dass eine minimale Anzahl von Defekten (4) innerhalb des Bereichs der Chips oder innerhalb einer minimalen Anzahl der Chips angetroffen werden, und eine maximale Anzahl von Defekten innerhalb eines Verschnittbereichs (11) zwischen einer äußeren Kontur der Struktur von Chips und einem äußeren kreisförmigen Umfang des Wafers angetroffen werden.

11. Verfahren nach dem vorhergehenden Anspruch, wobei die Struktur von Chips in einem digitalen volumetrischen 3D-Modell des Kristalls zur Berechnung des Versatzes enthalten ist, um die Defekte zu berücksichtigen, die in einem Verschnittbereich (11) zwischen dem äußeren Durchmesser des Wafers und den aus dem Wafer auszuschneidenden Chips positioniert sind.

12. System zur Herstellung von Wafern aus einem industriell gezüchteten Kristall, das dazu ausgestaltet ist, das Verfahren nach einem der Ansprüche 1 bis 11 durchzuführen, umfassend:
- einen Scanner zum Abtasten des Volumens eines Kristalls (1) und ein Programmmodul, das zum Bilden eines digitalen volumetrischen 3D-Modells des Kristalls aus einer Ausgabe des Scanners ausgestaltet ist,
- wobei das Programmmodul ferner zum Aufzeichnen räumlicher 3D-Koordinaten von Defekten (4, 4') ausgestaltet ist, die von dem Scanner festgestellt werden,
- wobei das Programmmodul dazu ausgestaltet ist, eine Versatzposition (O) eines Schneidwerkzeugs entlang einer ausgewählten Kristallachse zu berechnen, die dazu ausgestaltet ist, eine minimale Anzahl von Wafern mit Defekten aufzuweisen.

13. System nach dem vorhergehenden Anspruch, ferner umfassend:
- eine Messvorrichtung zum Messen einer oder mehrerer Kristallachsen (C1, C2, C3), die von einer kristallinen Struktur des Kristalls bereitgestellt werden, und Aufzeichnen der einen oder mehreren Kristallachsen in dem 3D-Modell des Kristalls.

14. System nach einem der zwei direkt vorhergehenden Ansprüche, ferner umfassend:
- eine Auskernungsvorrichtung zum Ausschneiden eines oder mehrerer zylindrischer Kerne (2) aus dem Kristall (1) in einer ausgewählten Kristallachsenrichtung, und
- eine Waferschneidmaschine, die ein Schneidwerkzeug umfasst, das eine Vielzahl von Schneiddrähten oder -klingen umfasst, die in einem gleichmäßigen Schneidabstand (G) beabstandet sind und dazu ausgestaltet sind, Wafer mit identischen Dicken (S) aus dem Kern auszuschneiden.

## Revendications

1. Procédé de production de galettes ou disques à partir d'un cristal ayant crû industriellement, comprenant les étapes de :
- balayage d'un cristal (1) en volume et formation d'un modèle numérique volumétrique tridimensionnel du cristal,
- enregistrement des coordonnées spatiales tridimensionnelles de défauts (4, 4') détectés durant ledit balayage,
- mesure d'un ou plusieurs axes du cristal (C1, C2, C3) fournis par la structure cristalline du cristal, et enregistrement de ces axes du cristal dans ledit modèle tridimensionnel du cristal,
- extraction d'une ou plusieurs carottes (2) hors du cristal (1) dans une direction de cristal sélectionnée qui est parallèle à l'un desdits axes du cristal ou à un angle défini par rapport audit axe du cristal,
- tranchage de la carotte orthogonalement à la direction de cristal sélectionnée avec une machine à trancher les galettes comprenant un outil de tranchage comprenant une pluralité de lames ou fils de coupe espacés selon un pas de tranchage régulier (G) et configurés pour découper des galettes ayant des épaisseurs identiques (S) à partir de la carotte,
- dans lequel le procédé comprend le calcul d'une position décalée (O) de l'outil de tranchage le long de la direction de cristal sélectionnée configurée pour avoir un nombre minimal de galettes avec des défauts, et
- ajustement de la position de l'outil de tranchage par rapport à la carotte le long de la direction de cristal sélectionnée en fonction du décalage calculé.

2. Procédé selon la revendication précédente, dans lequel la position décalée a une amplitude qui varie dans la plage allant de 0 à ladite épaisseur de pas de tranchage (G) des galettes.

3. Procédé selon l'une quelconque des revendications précédentes, dans lequel le balayage du cristal comprend un balayage optique du cristal.

4. Procédé selon l'une quelconque des revendications précédentes, dans lequel la carotte (2) est placée dans un support (8), le support et la carotte étant positionnés dans la machine à trancher.

5. Procédé selon la revendication précédente, dans lequel l'axe du cristal de la carotte est mesuré une fois de plus après que la carotte a été découpée à partir du cristal et la position de l'axe du cristal est ajustée au moyen du support de façon que l'outil de tranchage découpe des galettes orthogonalement à l'axe du cristal ajusté.

6. Procédé selon l'une quelconque des revendications précédentes, dans lequel une carotte de diamètre maximal *(Dmax)* découpée à partir du cristal est positionnée de façon qu'un nombre minimal de défauts soit trouvé, par calcul utilisant le modèle numérique volumétrique tridimensionnel, dans les galettes devant être découpées à partir du cristal.

7. Procédé selon l'une quelconque des revendications précédentes, dans lequel la valeur absolue du décalage est calculée par rapport à une position de référence sur la surface du cristal avant l'opération de carottage.

8. Procédé selon l'une quelconque des revendications précédentes, dans lequel l'étape de balayage de défauts et de géométrie du cristal est effectuée après une opération de rognage des extrémités supérieure et/ou inférieure du cristal brut.

9. Procédé selon l'une quelconque des revendications précédentes, dans lequel le cristal comprend une pluralité d'axes de cristal équivalents ou une pluralité de directions de cristal équivalentes (C1.1, C1.2, C1.3), le procédé comprenant la génération de plans plats (13a, 13b, 13c) croisant la carotte ou les galettes, les plans plats étant parallèles à un axe de la carotte et orthogonaux aux axes du cristal, le calcul du nombre de défauts entre lesdits plans plats et le contour extérieur de la carotte ou des galettes, la sélection de l'un desdits plans plats pour une découpe pour laquelle le nombre maximal de défauts (4') est positionné à l'intérieur de la zone de rebut (11) entre le plan plat et le contour extérieur.

10. Procédé selon l'une quelconque des revendications précédentes, dans lequel un motif non circulaire tel qu'un motif pour puces à semi-conducteur (12) devant être découpées à partir d'une galette (3) est orienté selon l'une parmi une pluralité de directions du cristal (C2.1, C2.2) calculées de façon qu'un nombre minimal de défauts (4) soit trouvé à l'intérieur de la zone des puces ou à l'intérieur d'un nombre minimal de puces, et qu'un nombre maximal de défauts soit trouvé à l'intérieur d'une zone de rebut (11) entre le contour extérieur du motif de puces et la périphérie circulaire extérieure de la galette.

11. Procédé selon la revendication précédente, dans lequel ledit motif de puces est inclus dans un modèle numérique volumétrique tridimensionnel du cristal pour le calcul du décalage afin que soient pris en considération les défauts positionnés dans une zone de rebut (11) entre le diamètre extérieur de la galette et les puces devant être découpées à partir de la galette.

12. Système pour produire des galettes à partir d'un cristal ayant crû industriellement, configuré pour exécuter le procédé de l'une quelconque des revendications 1 à 11, comprenant :
- un scanneur pour balayer un cristal (1) en volume et un module de programme configuré pour former un modèle numérique volumétrique tridimensionnel du cristal à partir d'une sortie du scanneur,
- le module de programme étant en outre configuré pour enregistrer des coordonnées spatiales tridimensionnelles de défauts (4, 4') détectés par le scanneur,
- dans lequel le module de programme est configuré pour calculer une position décalée (O) d'un outil de tranchage le long d'un axe de cristal sélectionné configuré pour avoir un nombre minimal de galettes avec des défauts.

13. Système selon la revendication précédente, comprenant en outre :
- un dispositif de mesure pour mesurer un ou plusieurs axes du cristal (C1, C2, C3) fournis par la structure cristalline du cristal, et enregistrer lesdits un ou plusieurs axes du cristal dans ledit modèle tridimensionnel du cristal.

14. Système selon l'une ou l'autre des deux revendications directement précédentes, comprenant en outre :
- un dispositif de carottage pour découper une ou plusieurs carottes cylindriques (2) à partir du cristal (1) dans une direction d'axe de cristal sélectionnée, et
- une machine à trancher les galettes comprenant un outil de tranchage comprenant une pluralité de lames ou fils de coupe espacés selon un pas de tranchage régulier (G) et configurés pour découper des galettes ayant des épaisseurs identiques (S) à partir de la carotte.
